# EUROPÄISCHE PATENTSCHRIFT

(11) **EP 1 808 924 B1**
(45) Veröffentlichungstag und Bekanntmachung des Hinweises auf die Patenterteilung: **23.12.2009**
(21) Anmeldenummer: 07000220.9
(22) Anmeldetag: 08.01.2007
(51) Int. Cl.: H01M 8/04, F28D 21/00

(54) **Anlage zur Kraft- Wärme-Kopplung**
Combined heat and power (CHP) system
Installation destinée au couplage force-chaleur

(30) Priorität: 13.01.2006 AT 522006
(43) Veröffentlichungstag der Anmeldung: 18.07.2007
(73) Patentinhaber: Vaillant GmbH, 42859 Remscheid (DE)
(72) Erfinder: Badenhop, Thomas, 51688 Wipperfürth (DE); Berg, Joachim, 42859 Remscheid (DE); Götz, Klaus, 42653 Solingen (DE); Kohlhage, Jörg, 45329 Essen (DE); Kraus, Matthias, 42929 Wermelskirchen (DE); Oerder, Bodo, 42897 Remscheid (DE); Paulus, Jochen, 42655 Solingen (DE)
(74) Vertreter: Hocker, Thomas

(56) Entgegenhaltungen:
- US-A1- 2003 035 985
- US-A1- 2004 265 661
- US-B1- 6 608 463

## Beschreibung

Die Erfindung bezieht sich auf eine Anlage zur Kraft-Wärme-Kopplung mit zumindest einer Brennstoffzelle sowie abwärmeerzeugenden elektrischen oder elektronischen Komponenten.

Brennstoffzellenanlagen liefern eine Gleichspannung, welche für übliche Anwendungen aufbereitet werden muss. Zumeist wird der Gleichstrom in Wechselstrom mit 50 Hz Wechselfrequenz umgesetzt. Hierzu ist ein Wechselrichter notwendig, welcher jedoch eine Verlustleistung, welche in Wärme übergeht, aufweist. Diese Abwärme muss abgeführt werden, um eine Überhitzung des Wechselrichters und somit dessen Zerstörung zu vermeiden.

Leistungselektroniken werden gemäß dem Stand der Technik auf unterschiedliche Arten gekühlt. Im einfachsten Fall erfolgt eine Kühlung durch freie Konvektion. Ein Kühlkörper gibt dabei Wärme an die Umgebungsluft ab, wobei die warme Luft aufsteigt. In einem besonders einfachen Fall wird ein Gehäuse der Elektronik als Kühlkörper verwandt.

In aufwändigeren Fällen geschieht eine geregelte Zwangsbelüftung. Hierbei wird über einen Ventilator Kühlluft dem Kühlkörper zugeführt.

Sowohl bei der freien Konvektion, als auch bei der Zwangsbelüftung erfolgt die Wärmeabfuhr in der Regel in die Umgebung und ist somit für die Wärmeanwendung verloren. Eine weitere Möglichkeit der Kühlung besteht darin, die abzuführende Wärme über einen Kühlkörper und einen diesen durchströmenden Kühlkreislauf, also ein Fluid, abzuführen. Dies setzt jedoch einen kühlen Fluidstrom voraus. Insbesondere bei Hochtemperaturbrennstoffzellen kann es vorkommen, dass durch den Fluidstrom die Elektronik erwärmt wird.

Die US 2002/0037444 A1 bzw. deren Prioritätsdokument DE 199 10 695 C1 offenbart, dass die Komponenten einer Kraft-Wärme-Kopplungsanlage mit Brennstoffzelle in einer Unterdruckkammer angeordnet sind, so dass die abgestrahlte Wärme größtenteils in der Unterkammer verbleibt. In der Unterdruckkammer befindet sich an einer Ecke eine Öffnung für die einströmende Luft und innerhalb der Unterdruckkammer ist eine Ansaugöffnung für die von den Komponenten benötigte Luft angeordnet. Die elektrische Anlagensteuerung befindet sich größtenteils im Strömungslee der Luft. Ein derartiger Aufbau ist auch aus der JP 2003208915 A bekannt.

Auch die US 2002/0168556 A1 zeigt, dass Luft an Bauteilen vorbeiströmt. Je ein Teilstrom der Luft strömt zur Brennstoffzelle und ein Teilstrom zur Batterie und dem DC-Konverter. Der Luftstrom erfolgt mehr oder minder zufällig entsprechend der Geometrie der Bauteile im Gehäuse.

Aus US 2003/0035985 A1 ist bekannt, dass die Kühlung von Brennstoffzellen und anderer Bauteile mittels Luftstrom erfolgen kann, wobei hier die Abwärme das System ungenutzt verlässt.

Die US 2004/0265661 A1 offenbart eine Anlage zur Kraft-Wärmekopplung mit Brennstoffzellen in einer Unterdruckkammer, bei der das Elektronikmodul durch Frischluft für den Betrieb der Brennstoffzellen gekühlt wird. Auch aus US 6 608 463 B1 ist bekannt, bei Brennstoffzellenanlagen Abwärme von Komponenten auf zugeführte Stoffströme zu übertragen und somit einen Teil der Energie, der für das Beheizen der zugeführten Stoffströme benötigt wird, hierfür zu nutzen. Es kann jedoch möglich sein, dass diese Kühlung nicht ausreicht die notwendige Wärmeabfuhr zu gewährleisten.

Bei Wechselrichtern entspricht eine Abwärme bis zu 10% durchaus dem Stand der Technik. Der Erfindung liegt somit die Aufgabe zugrunde, die Abwärme eines Wechselrichters oder allgemein einer Leistungselektronik einer Brennstoffzellenanlage zurückzugewinnen, um somit den Wirkungsgrad der Gesamtanlage zu steigern und gleichzeitig in dem Fall, in dem diese Form der Kühlung nicht ausreicht, die notwendige Wärmeabfuhr zu gewährleisten.

Erfindungsgemäß wird dies gemäß den Merkmalen des Anspruchs 1 dadurch erreicht, dass die abwärmeerzeugenden elektronischen oder elektrischen Komponenten oder deren Kühlkörper im Zuluftstrom der Brennstoffzelle und ggf. deren Hilfsaggregate angeordnet sind. Hierdurch wird erreicht, dass die Abwärme auf den Luftstrom übergeht und damit der Brennstoffzelle oder ihren Hilfsaggregaten zugeführt wird. Zusätzlich wird hierdurch eine Geräuschreduzierung erreicht. Ferner kann ein Gebläse sowohl die Funktion der Luftzuführung zur Brennstoffzellenanlage, als auch der Kühlluftförderung übernehmen. Dadurch, dass die zu kühlenden Komponenten unmittelbar im Inneren einer Zuluftleitung angeordnet sind, ist eine Beaufschlagung mit Zuluft sichergestellt. Es kann erfindungsgemäß die Zuluft zur Brennstoffzelle, die Luftluft zu den Hilfsaggregaten der Brennstoffzelle oder die Zuluft zu der Brennstoffzelle und deren Hilfsaggregaten zur Kühlung der abwärmeerzeugenden elektronischen oder elektrischen Komponenten oder deren Kühlkörper verwendet werden. Die abwärmeerzeugenden elektronischen oder elektrischen Komponenten und deren Kühlkörper befinden sich im Inneren einer Unterdruckkammer, welche zu dem die Verlustabgabe an die Umgebung minimiert. Die Flächen einer Unterdruckkammer oder eines sonstigen Gehäuseteils werden als Erweiterung der Kühlkörperfläche genutzt. Ein Teil der zu kühlenden Komponenten wird mit Kühlluft aus dem Aufstellraum gekühlt. Dies ist als Unterstützung der vorgenannten Kühlung anzusehen, was insbesondere dann notwendig sein kann, wenn in der Zuluftleitung oder Unterdruckkammer hohe Temperaturen herrschen und somit eine davon unabhängige Wärmeabfuhr sinnvoll erscheint. Ferner kann es sinnvoll sein, mittels des zweiten Lüfters gezielt besonders heiße Bauteile zu kühlen beziehungsweise Hotspots zu vermeiden.

In vorteilhafter Ausgestaltung gemäß den Merkmalen des abhängigen Anspruchs 2 ist die Zuluftleitung wärmegedämmt, so dass sichergestellt ist, dass keine Wärme an die Umgebung abgestrahlt werden kann. Die Zuluftleitung kann sich innerhalb oder außerhalb der Unterdruckkammer befinden.

Die Erfindung wird nun anhand der Figuren detailliert dargestellt.

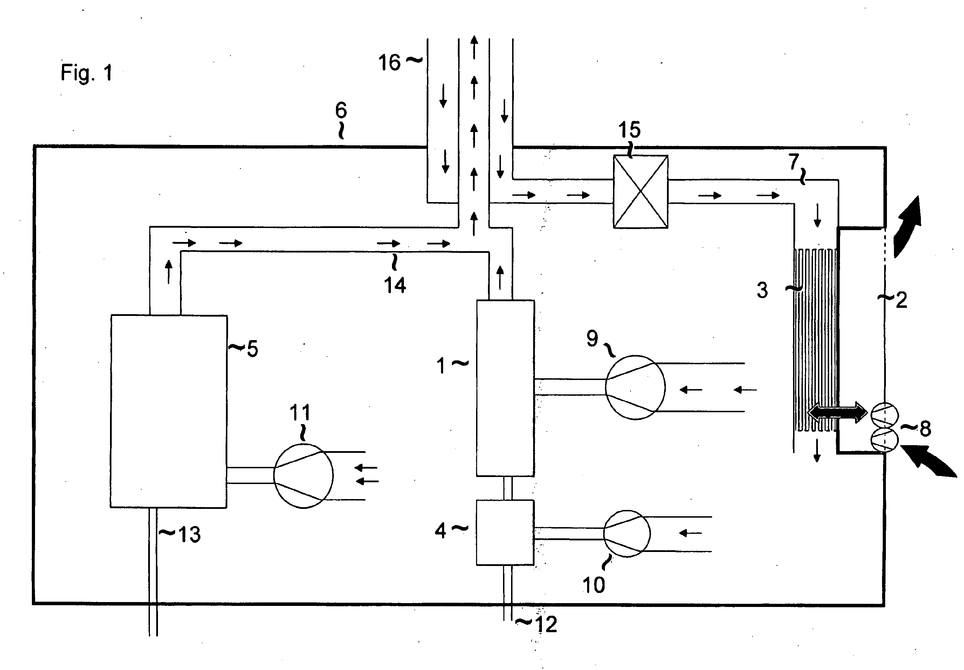

Figur 1 zeigt eine Anlage zur Kraft-Wärme-Kopplung mit einer Brennstoffzelle 1, einem Reformer 4, einem Zusatzheizgerät 5 sowie einem Wechselrichter 2 in einer Unterdruckkammer 6. Brennstoffzuführungen 12, 13 führen von außerhalb der Unterdruckkammer 6 zu dem Reformer 4 bzw. dem Zusatzheizgerät 5. Die Brennstoffzelle 1 verfügt ferner über ein Gebläse 9, durch das Luft aus der Unterdruckkammer zugeführt wird. Gleiches gilt für ein Gebläse 10, welches Luft dem Reformer 4 zuführt, als auch das Gebläse 11, welches Luft dem Zusatzheizgerät 5 zuführt. Brennstoffzelle 1 und Zusatzheizgerät 5 sind über eine Abgasleitung 14 mit einem koaxialen Abgasrohr 16 verbunden. Die äußere Leitung des koaxialen Abgassystems 16 führt zu einer Luftzufuhrführung 7, in der sich ein Luftfilter 15 befindet. Innerhalb der Luftzuführung 7 befindet sich der Wechselrichter 2 mit Kühlkörper 3. An der Außenseite der Unterdruckkammer 6 befindet sich ein Gebläse 8 im Bereich des Kühlkörpers 3.

Beim Betrieb zur Anlage der Kraft-Wärme-Koplung saugen die Gebläse 9, 10 Luft für die Brennstoffzelle 1 und den Reformer 4 an. Diese Luft wird über die Zuluftleitung 7 angesaugt. Nach der Reinigung im Luftfilter 15 strömt die Luft innerhalb der Zuluftleitung 7 an dem Wechselrichter 2 sowie dem Kühlkörper 3 vorbei und kühlt hierbei die elektronischen Komponenten, welche in nennenswertem Maße Abwärme erzeugen. In dem Reformer 4 wird aus einem Kohlenwasserstoff, welcher über die Brennstoffzuführung 12 zugeführt wird und Luft ein wasserstoffreiches Gas erzeugt, welches in der Brennstoffzelle 1 in Verbindung mit Luftsauerstoff zu Wasserdampf und elektrischer Energie umgewandelt wird. Die Abgase der Brennstoffzelle 1 gelangen über die Abgasführung 14 in das koaxiale Abgasrohr 16. Bei Bedarf wird in dem Zusatzheizgerät 5 Brenngas, welches durch die Brennstoffzuführung 13 in das Gerät gelangt, mit Luft verbrannt. Die Abgase gelangen über die Abgasleitung 14 in das koaxiale Abgassystem 16. Reicht die Kühlung des Wechselrichters 2 durch die im Zuluftkanal 7 abgegebene Wärme nicht aus oder sollen gezielt Hotspots vermieden werden, so wird zusätzlich das Gebläse 8 eingeschaltet, welches Frischluft aus dem Aufstellraum an einen Kühlkörper 3 des Wechselrichters 2 bläst, wodurch weitere Wärme abgegeben werden kann, die anschließend in den Aufstellraum gelangt. Diese Wärme ist zwar für das Gesamtsystem energetisch verloren, jedoch kann eine Beschädigung des Wechselrichters 2 hierdurch vermieden werden.

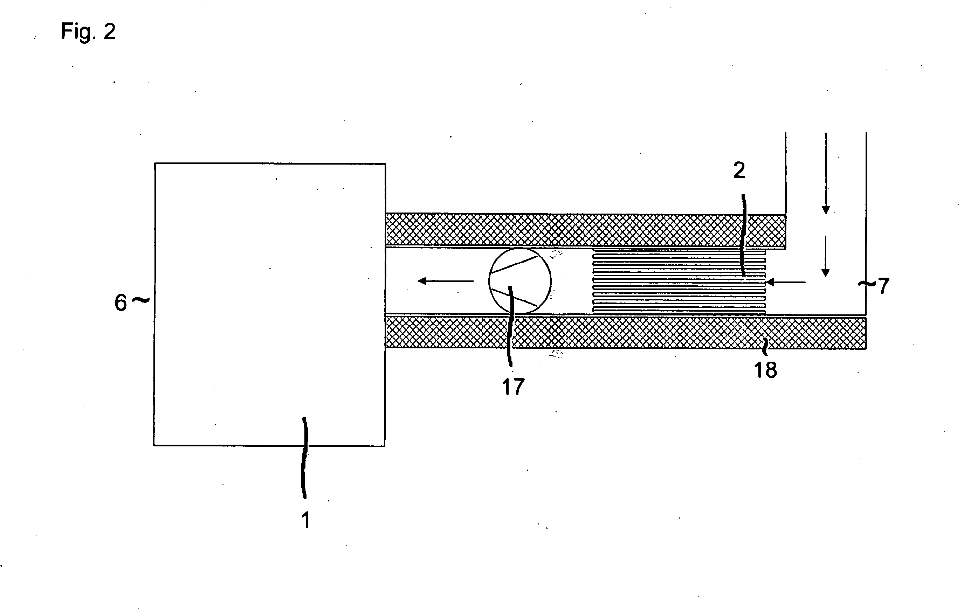

Figur 2 zeigt eine weitere Alternative der Wärmeabgabe. Der Wechselrichter 2 mit seinem Kühlkörper 3 befindet sich in der Zuluftleitung außerhalb der Unterdruckkammer 6, in der die Kraft-Wärme-Kopplungsanlage positioniert ist.

## Patentansprüche

1. Anlage zur Kraft-Wärme-Kopplung mit zumindest einer Brennstoffzelle (1) sowie abwärmeerzeugenden elektronischen oder elektrischen Komponenten, vorzugsweise einem Wechselrichter (2), vorzugsweise mit Hilfsaggregaten wie einem Reformer (4) und / oder einem Zusatzheizgerät (5), bei der die abwärmeerzeugenden elektronischen oder elektrischen Komponenten (2) oder deren Kühlkörper (3) im Zuluftstrom im Inneren einer Zuluftleitung (7) der zumindest einen Brennstoffzelle (1) und / oder deren Hilfsaggregate (4) im Inneren einer Unterdruckkammer (6) angeordnet sind, **dadurch gekennzeichnet, dass** mindestens ein Kühlkörper (3) mit der Unterdruckkammer (6) verbunden ist und ein mit dem Aufstellraum verbundenes Gebläse (8) die Außenseite der Unterdruckkammer (6) im Bereich des Kühlkörpers (3) mit Kühlluft, die anschließend wieder in den Aufstellraum geleitet wird, anströmt.

2. Anlage zur Kraft-Wärme-Kopplung nach Anspruch 1, **dadurch gekennzeichnet, dass** die Zuluftleitung (7) wärmegedämmt ist.

## Claims

1. A combined heat and power (CHP) system comprising at least one fuel cell (1) as well as waste heat emitting electronic or electric components, preferably a dc-ac converter (2), preferably with auxiliary units such as a reformer (4) and/or a supplementary heater (5), in which the waste heat emitting electronic or electric components (2) or the heat sinks (3) thereof are arranged in the interior of an air supply duct (7) of the at least one fuel cell (1) and/or the auxiliary units (4) thereof in the interior of a vacuum chamber (6), **characterised in that** at least one heat sink (3) is connected with the vacuum chamber (6) and that an air blower (8) connected with the installation room blows cooling air against the outside of the vacuum chamber (6) in the area of the heat sink (3), which cooling air is then again fed into the installation room.

2. A combined heat and power system in accordance with Claim 1 **characterised in that** the air supply line (7) is heat insulated.

## Revendications

1. Installation électrocalogène avec au moins une pile à combustible (1) ainsi que des composants électroniques ou électriques générant de la chaleur perdue, de préférence un onduleur (2), de préférence avec des modules auxiliaires tels qu'un reformeur (4) et/ou un appareil de chauffage supplémentaire (5), dans laquelle les composants électroniques ou électriques générant de la chaleur perdue (2) ou leurs corps de refroidissement (3) sont disposés dans le courant d'air amené à l'intérieur d'une conduite d'air amené (7) de l'au moins une pile à combustible (1) et/ou de ses modules auxiliaires (4) à l'intérieur d'une chambre de dépression (6), **caractérisée en ce qu'**au moins un corps de refroidissement (3) est relié à la chambre de dépression (6) et une soufflante (8) reliée à l'espace de montage souffle sur le côté extérieur de la chambre de dépression (6) dans la zone du corps de refroidissement (3) avec de l'air de refroidissement qui est ensuite redirigé dans l'espace de montage.

2. Installation électrocalogène selon la revendication 1, **caractérisée en ce que** la conduite d'air amené (7) est isolée thermiquement.
